Europäisches Patentamt

European Patent Office

Office européen des brevets

(19)

(11) Numéro de publication: **0 199 638**
**B1**

(12) **FASCICULE DE BREVET EUROPEEN**

(45) Date de publication du fascicule du brevet:
**25.01.89**

(51) Int. Cl.⁴: **C30B 13/34, C30B 13/24**

(21) Numéro de dépôt: **86400794.3**

(22) Date de dépôt: **14.04.86**

(54) **Procédé de fabrication sur un support isolant d'un film de silicium monocristallin orienté et à défauts localisés.**

(30) Priorité: **19.04.85 FR 8506001**

(43) Date de publication de la demande:
**29.10.86 Bulletin 86/44**

(45) Mention de la délivrance du brevet:
**25.01.89 Bulletin 89/4**

(84) Etats contractants désignés:
**DE GB IT NL**

(56) Documents cités:
**FR-A- 2 537 607**

**JOURNAL OF APPLIED PHYSICS,**
**vol. 55, no. 6, 15 mars 1984, pages 1607-1609, American Institute of Physics, New York, US; S. KAWAMURA et al.: "Laser recrystallization of Si over SiO2 with a heat-sink structure"**
**PATENTS ABSTRACTS OF JAPAN,**
**vol. 9, no. 71 (C-272)[1794], 30 mars 1985; & JP - A - 59 203 791 (KOGYO GIJUTSUIN(JAPAN)) 17-11-1984**

(73) Titulaire: **Haond, Michel, 5, rue d'Oisan,**
**F-38240 Meylan(FR)**

(72) Inventeur: **Haond, Michel, 5, rue d'Oisan,**
**F-38240 Meylan(FR)**

(74) Mandataire: **Mongrédien, André et al, c/o BREVATOME 25, rue de Ponthieu, F-75008 Paris(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

La présente invention a pour objet un procédé de fabrication, sur un support isolant, d'un film de silicium monocristallin orienté et à défauts localisés.

Elle s'applique en particulier dans le domaine de la fabrication des circuits intégrés MOS ou bipolaires, notamment à grande rapidité de fonctionnement, résistant aux radiations ionisantes et/ou fonctionnant sous haute tension et devant dissiper de fortes puissances. Elle s'applique aussi dans la réalisation des circuits de commande des écrans plats d'affichage matriciel sur des substrats amorphes transparents tels que le verre.

La technologie silicium sur isolant ou technologie SSI constitue une amélioration sensible par rapport aux techniques standard dans lesquelles les composants actifs des circuits intégrés sont réalisés directement sur un substrat monocristallin en silicium massif. En effet, l'emploi d'un corps isolant conduit à une forte diminution des capacités parasites entre la source et le substrat d'une part, et le drain et le substrat d'autre part, des composants actifs des circuits intégrés et donc à un accroissement de la vitesse de fonctionnement de ces circuits.

De plus, cette technologie SSI permet de diminuer fortement les charges parasites introduites dans les circuits intégrés fonctionnant sous radiations ionisantes, étant donné que ces radiations ne peuvent pas ioniser le support isolant à l'encontre d'un support en silicium massif. Par ailleurs, cette technologie permet une augmentation de la densité d'intégration des circuits intégrés du fait qu'elle permet notamment d'éviter le perçage (latch-up en terminologie anglo-saxonne) dû au claquage des jonctions de ces circuits intégrés.

Enfin, cette technologie conduit à une simplification notable des procédés de fabrication des circuits intégrés ainsi qu'à une meilleure tenue de ces 5 circuits aux hautes tensions.

L'obtention de films semiconducteurs monocristallins et notamment de silicium sur des supports isolants a été longuement étudiée plus spécialement en vue de la fabrication d'écrans plats et de leurs circuits de commande sur des substrats amorphes transparents. Lorsque les premières expériences utilisant des faisceaux lasers ou des faisceaux d'électrons ont montré qu'il était possible de faire croître des grains de silicium en les chauffant et surtout en fondant le silicium déposé, grâce à une technique de microfusion de zone, alors un regain d'activité s'est développé en vue de l'obtention de films de silicium monocristallin sur un support isolant.

Ce regain d'intérêt s'est traduit par la recherche de techniques permettant de traiter rapidement des plaquettes de silicium type industriel et en particulier dans la recherche de dispositifs de chauffage dont le coût est inférieur à celui d'une source laser ou d'un canon à électrons. C'est ainsi qu'ont été utilisées les résistances de graphite ou encore des lampes à filament ou à arc. Ces dispositifs de chauffage ont notamment été décrits dans un article de M.W. GEIS et a paru dans Applied Physics Letters, 37, de mai 1980, p. 454, et dans la demande de brevet n° 2 532 783 du 7 septembre 1982.

Malheureusement, aucune de ces techniques de chauffage connues n'a permis de produire jusqu'à ce jour des films de silicium monocristallin sans défaut sur la totalité de la surface d'une plaquette de silicium de dimensions industrielles (100 mm de diamètre).

Toutes les expériences semblent montrer que, même avec des faisceaux d'énergie non cohérente qui permettent de recristalliser des plaquettes de silicium entières en un seul passage, il est difficile d'envisager de supprimer les défauts résiduels tels que les joints et sous-joints de grains ou autres dislocations; ceci est d'autant plus vrai que les films de silicium sont des films minces, c'est-à-dire dont l'épaisseur est inférieure à 0,5 µm.

Par ailleurs, afin d'orienter le film semi-conducteur recristallisé, on a tenté d'utiliser un fin réseau gravé dans le support isolant comme décrit dans l'article de M.M. GEIS et al. paru dans Appl. Phys. Lett., H, 35, de juillet 1979, p. 71–74, intitulé "Crystallographic orientation of silicon on an amorphous substrate using an artificial surface – relief grating and laser crystallization". Malheureusement, les techniques employées en balayage de fusion de zones de silicium, telles que celles décrites dans l'article de M.W. GEIS et dans le document FR-A 2 532 783 cités ci-dessus, n'ont jamais permis d'obtenir des plaquettes de silicium recristallisées totalement orientées et sans défaut.

L'une des techniques la plus utilisée pour réaliser une couche de silicium monocristallin sur un support isolant consiste à former sur un substrat en silicium monocristallin d'orientation donnée, une couche d'oxyde de silicium notamment par oxydation thermique puis à déposer sur la couche d'oxyde de silicium une couche de silicium polycristallin et enfin à soumettre le film à un traitement thermique tel qu'un balayage d'une zone fondue du film afin de recristalliser le silicium.

Dans une telle technique, on a envisagé de réaliser dans la couche d'oxyde de silicium des ouvertures de manière à utiliser le substrat monocristallin comme germe de recristallisation afin d'orienter le film recristallisé et d'éviter sa désorientation qui sont les causes principales d'apparition de joints et de sous-joints de grains. Cette technique de germination a notamment été décrite dans l'article de M. FEN paru dans Appl. Phys. Lett., H, 38, de 1981, page 365.

Dans cette technique, il est apparu nécessaire de reproduire avec une période courte (inférieure à 500 µm) les ouvertures dites de germination dans la couche d'oxyde de silicium afin de ne pas perdre l'orientation de départ. Or, ceci a notamment pour inconvénient de nécessiter, après recristallisation du film de silicium, une étape d'oxydation localisée de ces zones de germination afin de bien isoler la couche semiconductrice recristallisée du substrat monocristallin et de pouvoir utiliser ensuite les différents avantages mentionnés ci-dessus sur la technologie SSI. De plus, ces zones oxydées entraînent une perte de place du fait qu'il ne sera pas possible de réaliser des circuits intégrés isolés les uns des autres sur ces zones oxydées.

Par ailleurs, on a étudié la formation et l'apparition des joints et sous-joints de grains dans le but de trouver des techniques de localisation de ces défauts dans des zones étroites où on ne fabriquerait pas les zones actives (les grilles des transistors) des circuits intégrés.

En particulier, par recristallisation du film semi-conducteur sur le support isolant par la technique de balayage d'une zone fondue de silicium, on a notamment pu remarquer que les joints et sous-joints de grains se formaient dans les zones qui se solidifiaient en dernier après le passage de la zone fondue.

En utilisant dans cette technique de recristallisation une source laser, où l'énergie peut être concentrée sur un spectre très étroit, il est possible de coupler plus ou moins l'énergie du faisceau laser avec le film semiconducteur et de chauffer plus ou moins telle ou telle zone dudit film par rapport à une autre. Ceci peut être réalisé, comme décrit dans la demande de brevet français n° 8 316 396, en utilisant sur le film de silicium à recristalliser des bandes parallèles antiréfléchissantes, jouant le rôle de retardateur de cristallisation, et en calculant l'épaisseur des bandes antiréfléchissantes et des bandes réfléchissantes (bandes de silicium) afin d'ajuster l'énergie du faisceau laser interagissant avec le film de silicium.

En revanche, dans le cas de source de lumière incohérente, étant donné leur large spectre d'émission, il est difficile d'ajuster les épaisseurs des bandes réfléchissantes et antiréfléchissantes pour tenter de mettre en phase les ondes lumineuses frappant la structure. Cependant, comme décrit dans un article de M.W. GEIS et al., paru dans J. Electrochem. Soc.: Solid-State Science and Technology, 130, p. 1178–1183 de mai 1983, intitulé "Solidification-Front Modulation to Entrain Sub-boundaries in Zone Melting Recrystallization of Si on SiO$_2$", on a utilisé des corps noirs ou des couches métalliques pour leurs propriétés réfléchissantes sur un large spectre.

De même, dans un article de D. BENSAHEL, et al., paru dans Electronics Letters du 23 juin 1983, vol. 19, n° 13, p. 464–466, intitulé "Localisation of defects on SOI films via selective recrystallization using halogen lamps", on a utilisé des couches déposées d'indice différent comme adaptation grossière d'indice de réfraction sans s'attacher à des épaisseurs minces et calibrées.

Dans un autre procédé de localisation des défauts résiduels dans le film de silicium recristallisé, on a modulé les isothermes de la zone fondue semiconductrice en utilisant une diffusion sélective de la chaleur dans le substrat sous-jacent, en faisant varier l'épaisseur de la couche d'oxyde de silicium supportant le film semiconducteur. Ce procédé utilisant comme source de chauffage une source laser a été décrit dans un article de S. KAWAMURA et al., paru dans J. Appl. Phys. 55 (6) du 15 mars 1984, p. 1607 à 1609, intitulé "Laser recrystallization of Si over SiO$_2$ with a heat-sink structure".

Lorsque l'on parvient à localiser les différents défauts de recristallisation du film de silicium, comme décrit précédemment, le principal problème restant encore est celui de l'orientation cristalline de ce film recristallisé. Si avec des faisceaux d'énergie non cohérente, le film recristallisé présente une texture (100) perpendiculaire au plan du film, dans le cas des faisceaux lasers, ce film n'est généralement pas orienté et on est donc obligé d'avoir recours à des ouvertures de germination vers le substrat monocristallin, pratiquées dans la couche d'oxyde de silicium. Avec des faisceaux d'énergie non cohérente cependant, le film de silicium reste désorienté dans le plan du film; la désorientation est d'environ 30° par rapport à la direction de déplacement de la zone fondue.

Dans le cas des faisceaux d'énergie non cohérente, d'autres problèmes demeurent et notamment la tenue des films semiconducteurs lors de la fusion de zone. En effet, lorsque le silicium est liquide et en contact avec de l'oxyde de silicium, généralement utilisé comme support isolant, le silicium ne mouille pas l'isolant et a tendance à se mettre en goutte. Aussi, faut-il trouver un "encapsulant" efficace, c'est-à-dire un élément enfermant le film semiconducteur, permettant de maintenir le film semiconducteur au contact du support isolant et donc d'éviter la mise en goutte du silicium ainsi que de limiter le transport de masse de silicium fondu.

Actuellement, on tente d'éviter la mise en goutte en recouvrant le film de silicium d'une couche épaisse d'oxyde de silicium ou de nitrure de silicium (2 µm pour un film de silicium de 0,5 µm). Mais même avec de telles épaisseurs de matériau, il arrive souvent que le silicium se mette en goutte, conduisant à l'obtention de plaquettes de silicium totalement inutilisables.

La présente invention a justement pour objet un procédé de fabrication d'un film de silicium monocristallin sur un support isolant permettant de remédier aux différents inconvénients cités ci-dessus. Ce procédé, utilisant la technique de fusion de zones pour former le film semiconducteur monocristallin, permet une localisation précise des défauts de cristallisation et la formation de monocristaux de silicium orientés perpendiculairement au plan du film de silicium.

De façon plus précise, l'invention a pour objet un procédé de fabrication d'un film de silicium monocristallin orienté et à défauts localisés sur un support isolant comprenant les étapes successives suivantes:

a) réalisation dans un support isolant, par gravure du support, de bandes isolantes en surplomb et de bandes en creux, parallèles et alternées, la largeur des bandes en surplomb étant plus faible que celle des bandes en creux,

b) dépôt sur l'ensemble de la structure obtenue d'un film de silicium,

c) recouvrement du film de silicium d'une couche d'un matériau encapsulant,

d) réalisation d'un traitement thermique de la structure obtenue afin de recristalliser le film de silicium sous forme monocristalline, ce traitement consistant à fondre localement le film de silicium et déplacer la zone fondue parallèlement aux bandes isolantes, la zone fondue ayant la forme d'un trait perpendiculaire auxdites bandes, et

e) élimination de la couche de matériau encapsulant.

La réalisation, par gravure du support isolant, de bandes en surplomb et de bandes en creux parallèles permet une bonne localisation des défauts résiduels de cristallisation du film de silicium.

En effet, les bandes ou parties en surplomb assurent la localisation des joints et sous-joints de grains grâce à une modulation de l'isotherme du front de cristallisation: la solidification est retardée dans les zones d'isolant les plus épaisses (parties en surplomb), du fait de la différence de conductivité thermique entre l'isolant épais et l'isolant mince. Les défauts de cristallisation sont donc localisés juste au-dessus des marches isolantes.

Par ailleurs, la configuration des bandes en surplomb et en creux permet d'éviter la mise en goutte du silicium en fusion sur l'isolant, lorsque celui-ci est de l'oxyde de silicium, ce qui permet notamment l'utilisation de couches de matériau encapsulant plus faibles que celles de l'art antérieur. Toutefois, si par hasard le silicium se mettait en goutte, le liquide resterait toutefois confiné entre deux parties en surplomb, le franchissement de ces parties en surplomb ou marches étant difficile.

De façon avantageuse, on utilise une configuration périodique, dans laquelle les bandes en surplomb et les bandes en creux sont régulièrement espacées les unes des autres. Ceci permet d'obtenir lors du traitement thermique, une répartition homogène de l'énergie absorbée et diffusée dans le film de silicium et le long de la zone fondue qui est perpendiculaire aux bandes isolantes.

L'utilisation d'une configuration périodique est particulièrement intéressante pour des raisons de traitement technologique ultérieur (réalisation de circuits intégrés). En effet, les concepteurs de circuits intégrés souhaitent pouvoir disposer des plus grandes régions monocristallines possibles sans défaut. Dès lors qu'une largeur critique des parties isolantes en creux a été déterminée, il est préférable de la répéter afin d'éviter une perte de place, en cas de diminution de cette largeur, ou une apparition de défaut, en cas d'augmentation de ladite largeur. De plus, une configuration périodique peut être intéressante lors de la fabrication de composants ou circuits reproduits périodiquement (matrice, mémoire, réseaux prédiffusés, etc...).

Afin de renforcer la localisation des défauts de recristallisation, on peut avantageusement former, avant l'étape d, sur la couche de matériau encapsulant et au-dessus de chaque bande en surplomb, une bande antiréfléchissante par exemple en nitrure de silicium de même largeur que celle de ladite bande en surplomb associée. Ces bandes antiréfléchissantes jouent le rôle de retardateur de cristallisation; elles renforcent la modulation de l'isotherme sur le front de solidification.

De façon à bien guider l'orientation cristalline du film de silicium recristallisé, la zone fondue sera déplacée à une vitesse lente, c'est-à-dire à une vitesse inférieure à 0,5 mm/s. De préférence, la vitesse de déplacement de la zone fondue varie de 0,1 à 0,2 mm/s.

De façon avantageuse, la zone fondue de silicium, ayant la forme d'un trait perpendiculaire aux bandes isolantes en surplomb ou en creux, est obtenue en soumettant l'ensemble de la structure à l'action d'une raie d'énergie, perpendiculaire à ces bandes isolantes, se déplaçant parallèlement à elles. De préférence, la raie d'énergie est obtenue par la focalisation de l'énergie d'une lampe linéaire placée au foyer d'un réflecteur elliptique. Elle peut aussi être formée en balayant rapidement la surface de la couche de matériau encapsulant, avec un faisceau laser ou un faisceau d'électrons, selon une direction perpendiculaire aux bandes isolantes.

Selon un mode préféré de mise en œuvre du procédé de l'invention, on réalise dans chaque partie en creux, par gravure du support isolant, au moins une encoche, ces encoches ayant la forme de bandes parallèles entre elles et aux parties en surplomb. De préférence, on réalise chacune des encoches au milieu d'une partie en creux.

La réalisation de ces encoches contribue fortement à orienter le film de silicium parallèlement au sens de déplacement de la zone fondue grâce à l'effet de grapho-épitaxie dans la zone de silicium qui solidifie en premier. La zone qui contient ces encoches fournit les germes possédant la bonne orientation ((100) parallèle aux bandes). L'orientation du film recristallisé provient d'une minimisation de l'énergie entre l'oxyde et le silicium orienté (100) (c'est-à-dire dont les plans (100) sont parallèles à la surface de l'oxyde). Ainsi, le fond et les côtés des parties en encoches, par minimisation de l'énergie, vont fournir des noyaux orientés (100) parallèlement aux bandes d'encoches qui constituent donc les noyaux sources de la germination longitudinale, parallèlement aux bandes isolantes, en surplomb et en creux. Ce sont ces noyaux qui restent solides au départ de la fusion en bordure de zone fondue.

Cette sélection d'orientation est d'autant plus efficace que le film de silicium déposé est du silicium amorphe et/ou lorsque le film de silicium déposé est du silicium polycristallin à grains petits devant la taille des encoches.

En cas de nécessité, on peut aplanir la surface du film de silicium déposé avant de le recristalliser. Ceci peut avantageusement être obtenu par la technique dite "de planarisation" consistant à recouvrir le film de silicium d'une couche d'un matériau isolant, et en particulier d'une résine telle que celle généralement utilisée en photolithographie, puis à graver simultanément cette couche de matériau isolant et le film de silicium, à des vitesses d'attaque identiques pour l'isolant et le silicium, jusqu'à élimination totale de l'isolant et des parties en relief du film de silicium.

De façon avantageuse, les gravures du support isolant pour former la configuration périodique et/ou les encoches sont réalisées par un procédé de gravure ionique réactive permettant ainsi d'obtenir des flancs gravés bien raides, perpendiculaires à la surface du support isolant.

Ces flancs raides améliorent notamment le mouillage du silicium liquide sur le support isolant ou plutôt bloque la mise en goutte du silicium fondu. Par ailleurs, ils peuvent avoir une influence dans l'orientation cristalline du silicium qui se solidifie.

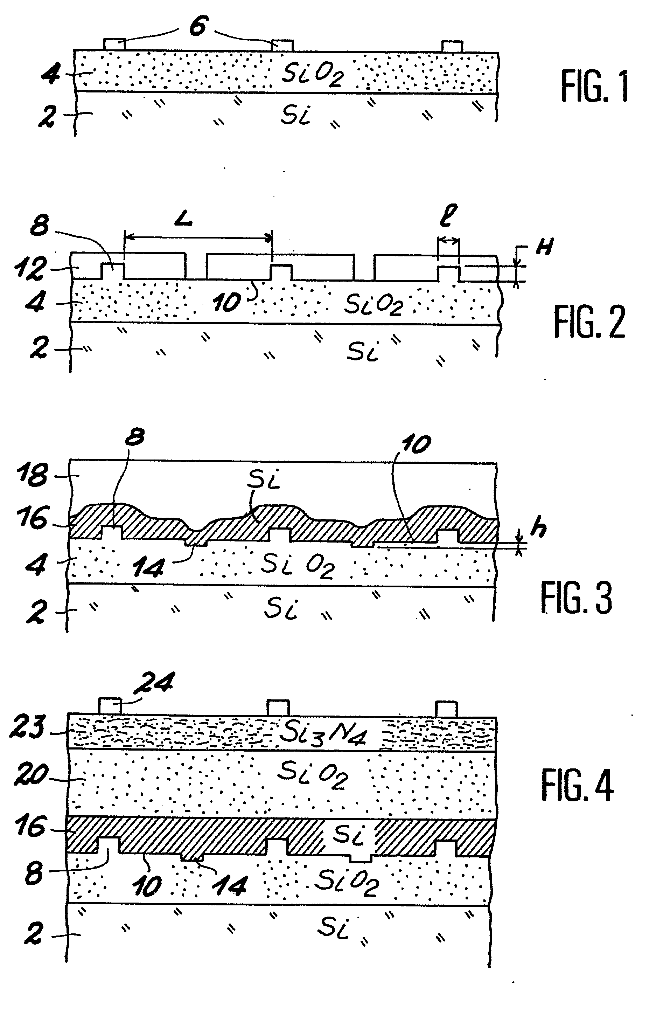

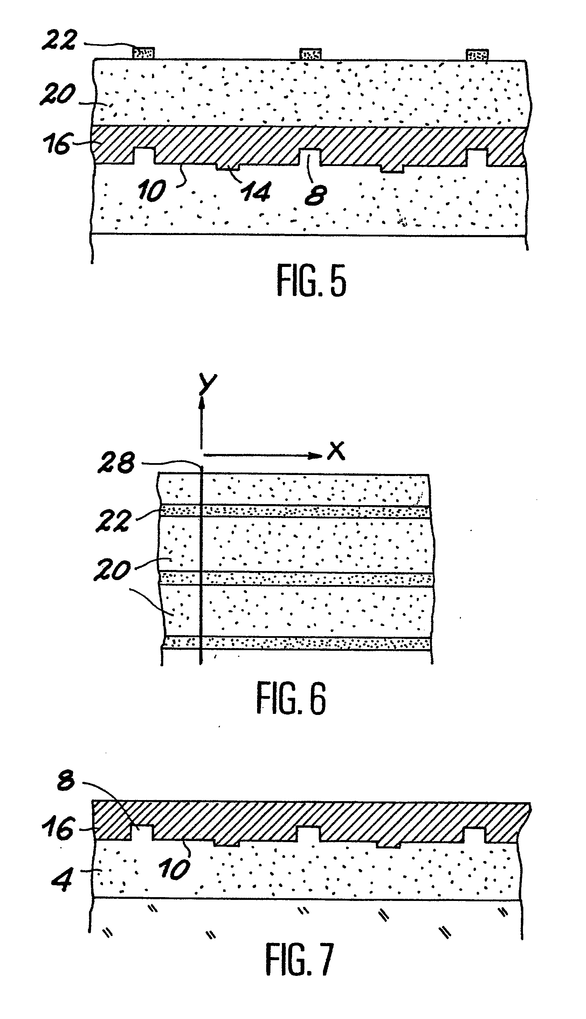

D'autres caractéristiques et avantages de l'invention ressortiront mieux de la description qui va suivre, donnée à titre illustratif et non limitatif, en référence aux figures 1 à 7, annexées, représentant les différentes étapes du procédé de fabrication d'un film de silicium monocristallin conformément à l'invention; les figures 1 à 5 et 7 sont des vues en coupe longitudinale et la figure 6 une vue de dessus.

La première étape du procédé, comme représentée sur la figure 1, consiste à recouvrir totalement la surface d'un substrat de silicium monocristallin 2 d'une couche de matériau isolant 4. Le substrat en silicium 2 présente par exemple une orientation cristalline (100), c'est-à-dire une orientation perpendiculaire à la surface du substrat. La couche de matériau isolant 4 peut être réalisée soit en oxyde de silicium, soit en nitrure de silicium.

Dans le cas d'une couche 4 en oxyde de silicium, celle-ci peut être obtenue par oxydation thermique du substrat 2, sous oxygène sec ou humide à une température de 800 à 1100°C. Cette couche d'oxyde 4 présente par exemple une épaisseur de 0,5 à 1,5 µm.

On réalise ensuite sur la couche isolante 4 un masque de gravure 6 permettant de définir l'emplacement et les dimensions des parties en surplomb ou marches à réaliser dans la couche isolante 4. Ce masque 6 est par exemple un masque de résine réalisé selon les procédés classiques de photolithographie.

On effectue ensuite à travers le masque 6, comme représenté sur la figure 2, une première gravure de la couche isolante 4 afin d'éliminer sur une hauteur H les régions de l'isolant non recouvertes de résine. Dans le cas d'une couche 4 d'oxyde de silicium de 1 µm d'épaisseur, cette hauteur H peut aller de 200 à 500 nm.

Afin d'obtenir des flancs gravés bien droits, la gravure de la couche d'isolant peut être réalisée de façon anisotrope au moyen d'un procédé de gravure ionique réactive (GIR) utilisant comme agent d'attaque un plasma de tétrafluorure de carbone (CF$_4$) ou de trifluorométhane (CHF$_3$) dans le cas d'une couche 4 en oxyde de silicium.

Cette gravure de la couche isolante 4 permet la formation d'une configuration de préférence périodique comportant des parties en surplomb ou marches 8 similaires et des parties en creux 10 semblables. Ces parties en surplomb 8 et en creux 10 présentent la forme de bandes isolantes parallèles qui sont de préférence régulièrement espacées les unes des autres; ces bandes isolantes 8 et 10 s'étendent avantageusement d'un bord à l'autre de la structure et sont situées dans le plan de la couche isolante.

La largeur L des parties en creux 10, au-dessus desquelles pourront être réalisées les zones actives des circuits intégrés, est supérieure à la largeur l des parties en surplomb ou marches 8. Par exemple les parties en surplomb 8, au-dessus desquelles seront localisés les défauts de cristallisation (joints, sous-joints de grains) du film de silicium monocristallin à réaliser, présentent une largeur l pouvant varier de 3 à 6 µm. En revanche, les zones en creux peuvent présenter une largeur L allant de 20 à 100 µm pour un substrat de 100 mm de diamètre.

Après gravure de la couche isolante 4, on élimine le masque de résine 6 par exemple par voie chimique en utilisant comme agent d'attaque l'acétone ou l'acide nitrique ou par l'action d'un plasma d'oxygène.

Sur la structure obtenue (figure 2), on réalise éventuellement un second masque de gravure 12 par exemple en résine, selon les procédés classiques de photolithographie, permettant de définir l'emplacement et les dimensions des encoches à réaliser éventuellement dans les parties ou bandes en creux 10 de la couche isolante 4.

On effectue alors, comme représenté sur la figure 3, une deuxième gravure de la couche isolante 4 afin d'éliminer sur une hauteur h les parties de cette couche isolante 4 non recouvertes de résine. Comme précédemment, cette gravure est réalisée de préférence de façon anisotrope afin de former des flancs raides. Cette gravure est par exemple une gravure ionique réactive utilisant comme agent d'attaque un plasma de tétrafluorure de carbone ou du trifluorométhane pour une couche 4 en oxyde de silicium. Cette gravure de la couche isolante peut être réalisée sur une hauteur h allant de 50 à 100 nm.

Les encoches obtenues, portant la référence 14, présentent la forme de bandes parallèles entre elles et parallèles aux bandes isolantes 8 et 10 de la couche isolante 4. Ces encoches 14 s'étendent avantageusement comme les marches 8 et parties en creux 10 d'un bout à l'autre de la couche isolante 4. La largeur de ces encoches peut aller de 100 à 1000 nm.

Ces encoches 14 permettront, lors de la recristallisation du film de silicium, de donner une orientation similaire du film de silicium dans toutes les parties en creux isolantes 10 et en particulier en utilisant un faisceau d'énergie non cohérente pour recristalliser le film de silicium.

Bien qu'il ne soit pas nécessaire que ces encoches 14 soient situées juste au milieu des parties en creux 10, ceci est préférable pour des raisons de symétrie de croissance du silicium.

Chaque encoche peut être avantageusement remplacées par un réseau périodique gravé dont la période est constituée de l'encoche élémentaire décrite.

Après réalisation des éventuelles encoches 14, on élimine le masque de résine 12 par exemple par voie chimique en utilisant comme agent d'attaque chimique acétone ou acide nitrique ou par action d'un plasma d'oxygène.

L'étape suivante du procédé, comme représenté sur la figure 3, consiste à recouvrir l'ensemble de la structure d'un film de silicium 16; ce silicium peut être soit du silicium amorphe, soit du silicium polycristallin. Ce film de silicium 16 présente une épaisseur allant de 0,2 à 1 µm. Lorsque le silicium déposé est du silicium polycristallin, le film de silicium peut être obtenu par un procédé de dépôt chimique en phase vapeur à basse pression (LPCVD), à une température de l'ordre de 625°C par pyrolyse de $SiH_4$.

Au cas où le film de silicium 16 ne présenterait pas une surface plane (figure 3), ce qui est le cas lorsque les parties en surplomb ou marches 8 sont relativement élevées par rapport à l'épaisseur du film de silicium, il est possible d'aplanir cette surface par un procédé dit "de planarisation". Cet aplanissement de la surface du film de silicium 16 a notamment pour effet de renforcer la localisation des défauts intervenant lors de la recristallisation de ce film, étant donné que la contribution énergétique des interfaces silicium-oxyde de silicium ne peut plus être négligée.

Cet aplanissement de la surface du film de silicium 16 (figure 4 ou 7) peut par exemple être obtenu en recouvrant, comme représenté sur la figure 3, ce film 16 d'une couche d'un matériau isolant 18 effaçant le relief du film de silicium 16. Cette couche isolante 18 est de préférence réalisée en résine telle que celle couramment utilisée en photolithographie. Le dépôt de cette couche de résine 18, présentant notamment une épaisseur de quelques μm, peut être suivi d'un traitement thermique, par exemple un chauffage à la température de l'ordre de 100°C pendant 30 mn, de façon à obtenir un bon étalement de cette couche de résine 18.

On réalise ensuite une gravure simultanée de la couche de résine 18 et du film de silicium 16, à des vitesses d'attaque identiques pour la résine et le silicium, jusqu'à élimination totale, comme représenté sur la figure 4, de la couche de résine 18 et donc des zones en relief du film de silicium 16. Cette gravure est réalisée de préférence de façon anisotrope par exemple par un procédé de gravure ionique réactive utilisant comme agent d'attaque un plasma d'hexafluorure de soufre et d'oxygène: le composé fluoré servant à la gravure du silicium et l'oxygène servant à la gravure de la résine.

L'étape suivante du procédé consiste à recouvrir le film de silicium 16 éventuellement aplani, d'une couche d'encapsulation 20 réalisée par exemple en oxyde de silicium ou en nitrure de silicium ou même sous forme d'un matériau bi-couche. Cette couche de matériau encapsulant, présente notamment une épaisseur allant de 1 à 1,5 μm. Elle peut être obtenue par un procédé de dépôt chimique en phase vapeur à basse pression et basse température (LTO), par exemple à 430°C par pyrolyse de $SiH_4+O_2$, lorsque ladite couche est en oxyde de silicium, ou par pulvérisation cathodique lorsque cette couche est en nitrure de silicium.

On réalise ensuite éventuellement sur la couche encapsulante 20 des bandes antiréfléchissantes 22 comme illustré sur la figure 5, coïncidant avec les parties en surplomb 8 de la couche isolante 4; chaque bande antiréfléchissante 22 est située au-dessus d'une partie isolante en surplomb 8. Ces bandes antireflet 22 s'étendent de part et d'autre de la structure et présentent une largeur identique à celle des parties en surplomb ou marches 8. Ces bandes 22 peuvent être réalisées en une résine carbonée comme celles décrites dans l'article de M.W. GEIS paru dans J. Electrochem. Soc. cité ci-dessus, ou bien en nitrure de silicium.

Dans le cas de bandes en nitrure de silicium, celles-ci peuvent être réalisées, comme représenté sur la figure 4, en déposant une couche de nitrure de silicium 23 sur la couche encapsulante 20 ayant une épaisseur allant de 80 à 150 nm. Cette couche de nitrure de silicium 23 peut par exemple être déposée par un procédé de dépôt chimique en phase vapeur (CVD) à une température de 800°C ou, dans le cas d'une couche encapsulante 20 en oxyde de silicium, par nitruration de cet oxyde à une température d'environ 950°C.

On réalise ensuite, sur la couche de nitrure 23, un masque de gravure 24 par exemple en résine par les procédés classiques de photolithographie. Ce masque de gravure 24 qui permet de définir l'emplacement et les dimensions des bandes antiréfléchissantes 24 à réaliser est identique au masque de résine 6, utilisé pour la gravure de la couche d'oxyde 4 pour former les parties isolantes en surplomb 8 et en creux 10.

A travers ce masque 24, on réalise une gravure de la couche de nitrure de silicium 23 jusqu'à élimination totale des parties de cette couche non recouvertes de résine. Cette gravure peut être réalisée, par voie chimique en utilisant comme agent d'attaque de l'acide orthophosphorique ou bien par un procédé de gravure ionique réactive utilisant un plasma d'hexafluorure de soufre comme agent d'attaque.

Cette gravure permet d'obtenir, comme représenté sur la figure 5, des bandes antiréfléchissantes 22 représentant le même motif que celui des parties en surplomb 8.

Ces bandes antiréfléchissantes 22 ont pour effet de renforcer lors de l'étape de recristallisation, la localisation des défauts de cristallisation (joints et sous-joints de grains) au-dessus des parties en surplomb 8. Ces bandes 24, adaptatrices d'indice de réfraction et retardatrices de recristallisation, permettent notamment de réduire la hauteur H des parties en surplomb 8 et donc de tendre vers un aplanissement de la surface du film de silicium 16; ceci permet de s'affranchir de l'étape dite de "planarisation" (figure 3) décrite ci-dessus.

L'étape suivante du procédé consiste à soumettre la structure obtenue, représentée sur la figure 5, à un traitement thermique permettant de recristalliser le film de silicium 16 sous forme monocristalline.

Ce traitement thermique comprend tout d'abord une étape de préchauffage consistant à placer l'ensemble de la structure dans un four et à porter celle-ci à une température inférieure à la température de fusion du silicium qui est de 1410°C. Par exemple la structure peut être portée à une température allant de 800 à 1200°C

Cette étape de préchauffage, dans le cas d'un film 16 en silicium amorphe, permet la cristallisation de celui-ci en gros grains de silicium polycristallin orientés suivant une orientation (100), parallèle et perpendiculaire aux flancs des encoches 14. Ce sont ces gros grains qui vont servir de germes à la recristallisation sous forme monocristalline ainsi qu'à l'orientation du silicium. L'orientation de ces gros grains de silicium est principalement due à l'existence des encoches 14.

Après cette étape de préchauffage, on fond localement le film de silicium 16 et on déplace la zone fondue ainsi obtenue selon une direction X (figure 6) parallèle aux bandes antiréfléchissantes 22, en cas d'utilisation de ces bandes, ou mieux parallèle aux bandes isolantes 8, suivant une vitesse relativement lente et notamment inférieure à 0,5 mm/s. De préférence, la vitesse de balayage de la zone fondue varie de 0,1 à 0,2 mm/s.

La zone fondue de silicium présente la forme d'un trait, par exemple de 2 à 5 mm de largeur dont la longueur est au moins égale à celle d'une plaquette de silicium de type industriel (100 mm de diamètre). Ce trait ou ligne de zone fondue peut avantageusement être réalisé, comme représenté sur la figure 6, en soumettant la surface de la structure à une raie d'énergie 28 orientée selon la direction Y, perpendiculaire aux bandes isolantes 8 ou aux bandes antiréfléchissantes 22, lorsque celles-ci existent. Cette raie d'énergie 28 se déplace parallèlement auxdites bandes selon la direction X.

Cette raie d'énergie 28 peut avantageusement être réalisée à l'aide d'un faisceau d'énergie de forte puissance focalisé à la surface de la structure, et notamment comme décrite dans la demande de brevet citée précédemment 8 316 396, en balayant rapidement la surface de la structure et notamment la couche de matériau encapsulant 20 avec un faisceau laser ou un faisceau d'électrons selon la direction Y, perpendiculaire aux bandes isolantes 8 ou aux bandes antiréfléchissantes 22.

Dans le cas d'un faisceau laser, ce balayage rapide selon Y peut être réalisé à une fréquence supérieure à 10 kHz. Par ailleurs, la puissance laser utilisée peut être comprise entre 10 et 25 W.

L'étape suivante du procédé consiste, comme représenté sur la figure 7, à éliminer les éventuelles bandes antiréfléchissantes 22, par exemple par voie chimique en utilisant un bain d'acide orthophosphorique lorsque les bandes antiréfléchissantes sont réalisées en nitrure de silicium. De même, on élimine la couche de matériau encapsulant 20 par attaque chimique dans un bain d'acide fluorhydrique lorsque cette couche est réalisée en oxyde de silicium. La structure finale est celle représentée sur la figure 7.

Le procédé décrit précédemment permet d'obtenir de larges bandes (parties en creux 10) de silicium monocristallin exemptes de défaut, par exemple de 40 μm de large et de 100 mm de long, présentant une orientation (100), sur lesquelles peuvent être réalisées les zones actives des circuits intégrés notamment MOS ou bipolaires; les défauts résiduels tels que les joints et sous-joints de grains ou autres dislocations, qui ne peuvent être supprimés lors de la cristallisation du film de silicium, sont exclusivement situés entre ces bandes monocristallines, cest-à-dire au niveau des marches 8, typiquement de 4 μm de large et de 100 mm de long.

Les différentes étapes du procédé selon l'invention présentent l'avantage d'être simples, facilement reproductibles et d'être bien maîtrisées par l'homme du métier.

La description donnée précédemment n'a bien entendu été donnée qu'à titre explicatif, toutes modifications, sans pour autant sortir du cadre de l'invention, pouvant être envisagées.

En particulier, l'épaisseur des différentes couches, la nature de celles-ci ainsi que leurs procédés de dépôt et leurs procédés de gravure peuvent être modifiés. De même, les dimensions des bandes isolantes 8 et 10, des encoches 14 et des bandes antireflet peuvent être modifiées. En outre, leur disposition ne forme pas nécessairement une structure périodique.

Par ailleurs, certaines étapes du procédé peuvent être, dans certains cas, supprimées. Par exemple les étapes conduisant à la réalisation des encoches 14 dans le support isolant ne sont pas nécessaires lorsque le film de silicium déposé sur ce support est un film de silicium polycristallin.

De même, si les parties en surplomb ou marches 8 présentent une hauteur H relativement importante, c'est-à-dire supérieure à 0,5 μm pour une couche isolante de 1 μm, il ne sera pas nécessaire d'utiliser des bandes 22 adaptatrices d'indice ou retardatrices de solidification pour permettre une bonne localisation des défauts de cristallisation du silicium au niveau des marches isolantes 8. En revanche, l'utilisation de marches 8 d'épaisseur élevée nécessitent d'avoir recours à une étape de "planarisation" si l'on désire obtenir un film de silicium ayant une surface parfaitement plane (figure 7). Dans le cas d'un film de silicium épais (environ 1 μm), les différentes techniques de dépôt de silicium connues par l'homme du métier permettent d'obtenir un film comportant une surface suffisamment plane, sans pour cela utiliser l'étape dite de "planarisation".

En outre, le traitement thermique permettant la cristallisation du film de silicium peut être réalisé avec un autre procédé que celui décrit. En particulier, le préchauffage de la structure et le balayage rapide selon une direction Y perpendiculaire aux marches isolantes 8 d'un faisceau laser ou d'électrons peuvent être réalisés en utilisant le dispositif de chauffage décrit dans la demande de brevet français n° 2 532 783.

Enfin, on a décrit une recristallisation du film de silicium isolé sur un substrat d'orientation mais toute autre orientation peut être envisagée. On peut même envisager d'utiliser des substrats polycristallins.

## Revendications

1. Procédé de fabrication d'un film (16) de silicium monocristallin orienté et à défauts localisés sur un support isolant (4) comprenant les étapes successives suivantes:

a) réalisation dans le support isolant (4), par gravure dudit support (4), de bandes isolantes en surplomb (8) et de bandes en creux (10), parallèles et alternées, la largeur des bandes en surplomb (8) étant plus faible que celle des bandes en creux (10),

b) dépôt sur l'ensemble de la structure obtenue d'un film de silicium (16),

c) recouvrement du film de silicium (16) d'une couche d'un matériau encapsulant (20),

d) réalisation d'un traitement thermique de la structure obtenue afin de recristalliser le film de silicium (16) sous forme monocristalline, ce traitement consistant à fondre localement le film de silicium (16) et à déplacer la zone fondue parallèlement aux bandes isolantes, la zone fondue ayant la forme d'un trait perpendiculaire auxdites bandes (8, 10), et

e) élimination de la couche de matériau encapsulant (20).

2. Procédé de fabrication selon la revendication 1, caractérisé en ce que les bandes en surplomb et les bandes en creux sont disposées selon une configuration périodique.

3. Procédé de fabrication selon la revendication 1 ou 2, caractérisé en ce que, avant l'étape d, on forme sur la couche de matériau encapsulant (20) et audessus de chaque bande en surplomb (8), une bande antiréfléchissante (22) de même largeur que celle de ladite bande en surplomb (8) associée.

4. Procédé de fabrication selon l'une quelconque des revendications 1 à 3, caractérisé en ce que l'on déplace la zone fondue à une vitesse inférieure à 0,5 mm/s.

5. Procédé de fabrication selon l'une quelconque des revendications 1 à 4, caractérisé en ce que l'on déplace la zone fondue à une vitesse allant de 0,1 à 0,2 mm/s.

6. Procédé de fabrication selon l'une quelconque des revendications 1 à 5, caractérisé en ce que l'on réalise le traitement thermique en soumettant la structure à l'action d'une raie d'énergie (28) perpendiculaire aux bandes isolantes (8, 10) et se déplaçant parallèlement aux dites bandes (8, 10).

7. Procédé de fabrication selon la revendication 5, caractérisé en ce que l'on forme la raie d'énergie (28) en balayant rapidement la surface de la couche de matériau encapsulant (20) avec un faisceau d'énergie selon une direction (Y) perpendiculaire aux bandes isolantes (8, 10).

8. Procédé de fabrication selon l'une quelconque des revendications 1 à 7, caractérisé en ce que l'on réalise dans chaque bande en creux (10), par gravure de support isolant, au moins une encoche (14), ces encoches ayant la forme de bandes parallèles aux bandes en surplomb (8).

9. Procédé de fabrication selon la revendication 8, caractérisé en ce que l'on réalise chaque encoche (14) au milieu de chaque partie en creux (10).

10. Procédé de fabrication selon l'une quelconque des revendications 3 à 9, caractérisé en ce que l'on forme les bandes antiréfléchissantes (22) en recouvrant la couche de matériau encapsulant (20) d'une couche d'un matériau antiréfléchissant (23) et en gravant cette couche antiréfléchissante (23) selon un motif identique à celui des bandes en surplomb (8).

11. Procédé de fabrication selon l'une quelconque des revendications 1 à 10, caractérisé en ce qu'avant l'étape c, on dépose une couche d'un matériau isolant (18) sur le film de silicium (16) effaçant le relief du film de silicium et on grave simultanément la couche de matériau isolant (18) et le film de silicium (16) avec des vitesses d'attaque identiques pour l'isolant et le silicium, jusqu'à élimination totale de ladite couche de matériau isolant (18) et des parties en relief du film de silicium (16), afin d'aplanir la surface dudit film de silicium (16).

12. Procédé de fabrication selon la revendication 8, caractérisé en ce que l'on grave le support isolant (4) pour former les bandes en creux (10) et/ou les encoches (14) par un procédé de gravure ionique réactive.

13. Procédé de fabrication selon l'une quelconque des revendications 1 à 12, caractérisé en ce que le support isolant (4) et/ou la couche de matériau encapsulant (20) sont réalisés en oxyde de silicium.

14. Procédé de fabrication selon l'une quelconque des revendications 1 à 13, caractérisé en ce que l'étape b consiste à déposer un film de silicium amorphe (16) ou polycristallin.

15. Procédé de fabrication selon l'une quelconque des revendications 1 à 14, caractérisé en ce que le traitement thermique comprend une étape de préchauffage de la structure obtenue, à une température inférieure à la température de fusion du silicium.

16. Procédé de fabrication selon l'une quelconque des revendications 3 à 15, caractérisé en ce que les bandes antiréfléchissantes (22) sont des bandes de nitrure de silicium.

## Patentansprüche

1. Verfahren zur Herstellung eines gerichteten einkristallinen Siliciumfilms (16) mit lokalisierten Fehlern auf einem Isoliersubstrat (4), enthaltend die folgenden aufeinanderfolgenden Schritte:

a) Herstellen von vorstehenden Isolierbändern (8) und von vertieften Bändern (10) parallel und abwechselnd nebeneinander in dem Isoliersubstrat (4) durch Ätzung des Substrats (4), wobei die Breite der vorstehenden Bänder (8) geringer ist als die der vertieften Bänder (10),

b) Aufbringen eines Siliciumfilms (16) auf den so erhaltenen Gesamtaufbau,

c) Bedecken des Siliciumfilms (16) mit einer Schicht aus einer Vergußmasse (20),

d) Ausführung einer thermischen Behandlung des erhaltenen Aufbaus, um den Siliciumfilm (16) in einkristalline Form zu rekristallisieren, wobei diese Behandlung darin besteht, den Siliciumfilm (16) lokal zu schmelzen und die geschmolzene Zone parallel zu den isolierenden Bändern zu verschieben, wobei die geschmolzene Zone die Form eines Striches hat, der senkrecht zu den genannten Bändern (8, 10) verläuft, und

e) Beseitigen der Schicht aus Vergußmasse (20).

2. Herstellungsverfahren nach Anspruch 1, dadurch gekennzeichnet, daß die vorstehenden Bänder und die vertieften Bänder in einer periodischen Konfiguration angeordnet sind.

3. Herstellungsverfahren nach Anspruch 1 oder 2, dadurch gekennzeichnet, daß vor dem Schritt d man auf der Schicht aus Vergußmasse (20) und über jedem vorstehenden Band (8) ein Antireflexband (22) gleicher Breite wie die des zugehörigen vorstehenden Bandes (8) ausgebildet.

4. Herstellungsverfahren nach einem der Ansprüche 1 bis 3, dadurch gekennzeichnet, daß man die geschmolzene Zone mit einer Geschwindigkeit von weniger als 0,5 mm/s verschiebt.

5. Herstellungsverfahren nach einem der Ansprüche 1 bis 4, dadurch gekennzeichnet, daß man die geschmolzene Zone mit einer Geschwindigkeit zwischen 0,1 und 0,2 mm/s verschiebt.

6. Herstellungsverfahren nach einem der Ansprüche 1 bis 5, dadurch gekennzeichnet, daß man die thermische Behandlung ausführt, indem man den Aufbau der Wirkung eines Energiestreifens (28) aussetzt, der sich senkrecht zu den isolierenden Bändern (8, 10) erstreckt und sich parallel zu den genannten Bändern (8, 10) verschiebt.

7. Herstellungsverfahren nach Anspruch 5, dadurch gekennzeichnet, daß man den Energiestreifen (28) ausbildet, indem ein Energiestrahl schnell über die Oberfläche der Vergußmasseschicht (20) in einer Richtung (Y) abgelenkt wird, die senkrecht zu den isolierenden Bändern (8, 10) verläuft.

8. Herstellungsverfahren nach einem der Ansprüche 1 bis 7, dadurch gekennzeichnet, daß man in jedem vertieften Band (10) durch Ätzung des Isoliersubstrats wenigstens eine Rinne (14) ausbildet, wobei die Rinnen die Form von Bändern haben, die parallel zu den vorstehenden Bändern (8) sind.

9. Herstellungsverfahren nach Anspruch 8, dadurch gekennzeichnet, daß man jede Rinne (14) in der Mitte eines jeden vertieften Abschnitts (10) ausbildet.

10. Herstellungsverfahren nach einem der Ansprüche 3 bis 9, dadurch gekennzeichnet, daß man die Antireflexbänder (22) ausbildet, indem man die Vergußmasseschicht (20) mit einer Schicht aus einem Antireflexmaterial (23) bedeckt und man diese Antireflexschicht (23) gemäß einem Muster, das mit dem der vorstehenden Bänder (8) identisch ist, ätzt.

11. Herstellungsverfahren nach einem der Ansprüche 1 bis 10, dadurch gekennzeichnet, daß vor dem Schritt c man auf dem Siliciumfilm (16) eine Schicht aus einem Isoliermaterial (18) aufbringt, die das Relief des Siliciumfilms auslöscht und man die Isoliermaterialschicht (18) und den Siliciumfilm (16) mit für die Isolation und das Silicium gleichen Angriffsgeschwindigkeiten simultan bis zur völligen Beseitigung der Isoliermaterialschicht (18) und der Reliefabschnitte des Siliciumfilms (16) ätzt, um die Oberfläche des genannten Siliciumfilms (16) zu ebnen.

12. Herstellungsverfahren nach Anspruch 8, dadurch gekennzeichnet, daß man das Isoliersubstrat (4) zur Ausbildung der vertieften Bänder (10) und/oder der Rinnen (14) mit einem reaktiven Ionenätzverfahren ätzt.

13. Herstellungsverfahren nach einem der Ansprüche 1 bis 12, dadurch gekennzeichnet, daß das Isoliersubstrat (4) und/oder die Vergußmasseschicht (20) aus Siliciumoxid bestehen.

14. Herstellungsverfahren nach einem der Ansprüche 1 bis 13, dadurch gekennzeichnet, daß der Schritt b darin besteht, einen Film (16) aus amorphem oder polykristallinem Silicium aufzubringen.

15. Herstellungsverfahren nach einem der Ansprüche 1 bis 14, dadurch gekennzeichnet, daß die thermische Behandlung einen Vorwärmschritt des erhaltenen Aufbaus auf eine unter der Schmelztemperatur von Silicium liegenden Temperatur umfaßt.

16. Herstellungsverfahren nach einem der Ansprüche 3 bis 15, dadurch gekennzeichnet, daß die Antireflexbänder (22) Bänder aus Siliciumnitrid sind.

**Claims**

1. Process for the production of an oriented monocrystalline silicon film (16) with localized defects on an insulating support (4) comprising the following successive stages:

a) producing in an insulating support (4) by etching the latter, overhanging insulating strips (8) and recessed strips (8), which are parallel and alternate, the width of the overhanging strips (8) being less than that of the recessed strips (10),

b) deposition on the complete structure obtained of a silicon film (16),

c) covering the silicon film (16) with an encapsulating material layer (20),

d) carrying out a heat treatment to the structure obtained in order to recrystallize the silicon film (16) in monocrystalline form, said treatment consisting of locally melting the silicon film (16) and moving the melted zone parallel to the insulating strips, the melted zone being in the form of a line perpendicular to said strips (8, 10), and

e) eliminating the encapsulating material layer (20).

2. Production process according to claim 1, characterized in that the overhanging and recessed strips are arranged according to a periodic configuration.

3. Production process according to claim 1 or 2, characterized in that, prior to stage d), an antireflecting strip (22) is formed on the encapsulating material layer (20) and above each overhanging strip (8) and has the same width as the associated overhanging strip (8).

4. Production process according to any one of the claims 1 to 3, characterized in that the melted zone is displaced at a speed below 0.5 mm/s.

5. Production process according to any one of the claims 1 to 4, characterized in that the melted zone is displaced at a speed of 0.1 to 0.2 mm/s.

6. Production process according to any one of the claims 1 to 5, characterized in that the treatment takes place by subjecting the structure to the action of an energy line (28) perpendicular to the insulting strips (8, 10) and moving parallel to said strips (8, 10).

7. Production process according to claim 5, characterized in that the energy line (28) is formed by rapidly scanning the surface of the encapsulating material layer (20) with an energy beam in a direction (Y) perpendicular to the insulating strips (8, 10).

8. Production process according to any one of the claims 1 to 7, characterized in that at least one notch (14) is formed in each recessed strip (10), by etching the insulating support, said notches being in the form of strips parallel to the overhanging strips (8).

9. Production process according to claim 8, characterized in that each notch (14) is produced in the centre of each recessed part (10).

10. Production process according to any one of the claims 3 to 9, characterized in that the antireflecting strips (22) are formed by covering the encapsulating material layer (20) with a layer of an antireflecting material (23) and by etching the latter with a pattern identical to that of the overhanging strips (8).

11. Production process according to any one of the claims 1 to 10, characterized in that before stage c), an insulating material layer (18) is deposited on the silicon film eliminating the relief of the latter, followed by the simultaneous etching of the insulating material layer (18) and the silicon film (16) at identical etching speeds for insulant and silicon until the insulating material layer (18) and the relief parts of the silicon film (16) are completely eliminated, in order to flatten the surface of said silicon film (16).

12. Production process according to claim 8, characterized in that the insulating support (4) is etched to form recessed strips (10) and/or notches (14) by a reactive ionic etching process.

13. Production process according to any one of the claims 1 to 12, characterized in that the insulating support (4) and/or encapsulating material layer (20) are made from silicon oxide.

14. Production process according to any one of the claims 1 to 13, characterized in that stage b) consists of depositing an amorphous or polycrystalline silicon film (16).

15. Production process according to any one of the claims 1 to 14, characterized in that the heat treatment comprises a stage of preheating the structure obtained at a temperature below the melting point of the silicon.

16. Production process according to any one of the claims 3 to 15, characterized in that the antireflecting strips (22) are silicon nitride strips.

FIG. 1

FIG. 2

FIG. 3

FIG. 4

FIG. 5

FIG. 6

FIG. 7